# EUROPÄISCHE PATENTSCHRIFT

(11) **EP 2 868 170 B1**
(45) Veröffentlichungstag und Bekanntmachung des Hinweises auf die Patenterteilung: **24.07.2019**
(21) Anmeldenummer: 13753805.4
(22) Anmeldetag: 25.06.2013
(51) Int. Cl.: H05K 1/18, H05K 3/00

(54) **VERFAHREN ZUM EINBETTEN ZUMINDEST EINES BAUTEILS IN EINE LEITERPLATTE**
METHOD FOR EMBEDDING AT LEAST ONE COMPONENT INTO A PRINTED CIRCUIT BOARD
PROCÉDÉ PERMETTANT D'INTÉGRER AU MOINS UN COMPOSANT DANS UNE CARTE DE CIRCUIT IMPRIMÉ

(30) Priorität: 02.07.2012 AT 7402012
(43) Veröffentlichungstag der Anmeldung: 06.05.2015
(73) Patentinhaber: AT & S Austria Technologie & Systemtechnik Aktiengesellschaft, 8700 Leoben-Hinterberg (AT)
(72) Erfinder: SCHRITTWIESER, Wolfgang, A-8605 Kapfenberg (AT)
(74) Vertreter: Patentanwaltskanzlei Matschnig & Forsthuber OG
(86) Internationale Anmeldenummer: PCT/AT2013/050128
(87) Internationale Veröffentlichungsnummer: WO 2014/005167

(56) Entgegenhaltungen:
- WO-A1-2005/104636
- WO-A1-2010/048654
- WO-A2-2006/013230
- US-A1- 2009 205 859
- US-A1- 2009 293 271

## Beschreibung

Die Erfindung bezieht sich auf ein Verfahren zum Einbetten zumindest eines Bauteiles, das auf einer unteren Leiterfolie durch Kleben befestigt ist und dessen Anschlussflächen nach oben zeigen, in eine Leiterplatte.

Ebenso bezieht sich die Erfindung auf eine Leiterplattenstruktur mit zumindest einem eingebetteten Bauteil, das auf einer unteren Leiterfolie durch Kleben befestigt ist und dessen Anschlussflächen nach oben zeigen, welche gemäß einem Verfahren nach der Erfindung hergestellt ist.

Ein Bauteil, wie z.B. ein Chip, kann prinzipiell "face down" oder "face up" in eine Leiterplatte eingebettet werden. Im erstgenannten Fall wird die Kontakte aufweisende Bauteilseite mit einer metallischen Leiterschicht verbunden, wie z.B. in der WO 2012/016258 A2 der Anmelderin gezeigt, im zweitgenannten Fall wird das Bauteil umgedreht mit der metallischen Leiterschicht verbunden, d.h. das Verkleben erfolgt, wie bei einem Verfahren der gegenständlichen Art, an der von den Kontakten abgewandten Seite des Bauteils. Verfahren dieser Art gehen z.B. aus den WO 2007/087660 A1 und WO 2009/143550 A1 der Anmelderin hervor.

Bei "face down" Einbettungsverfahren hat oft die Feuchtigkeitsaufnahme von Polyimid-Passivierungsschichten einen ungünstigen Einfluss auf die Qualität eines solchermaßen hergestellten Leiterplattenmoduls. Die Restfeuchtigkeit verbleibt nämlich an der auf der metallischen Leiterschicht aufgeklebten Unterseite des Bauteils. Weiters entstehen z.B. durch Inhomogenitäten des Klebers mit Luft/Gas und Feuchtigkeit gefüllte Hohlräume, die nach dem Aushärten des Klebers verbleiben. Derartige Inhomogenitäten können die zuverlässige Ankontaktierung der Bauteile, die durch die metallische Leiterschicht hindurch erfolgt, nachteilig beeinflussen. Die oben genannte WO 2012/016258 A2 beschäftigt sich mit diesem Problem und schlägt einen Lösungsversuch auf Basis eines speziellen Klebers und Klebeverfahrens vor.

Da bei "face up" Einbettungsverfahren jene Seite eines Bauteils auf der metallischen Leiterschicht geklebt wird, die im Allgemeinen keine Kontakte trägt, sind die zuvor genannten Probleme beseitigt oder doch zumindest drastisch vermindert.

Ein weiteres Problem liegt ganz allgemein darin, dass die Bearbeitung, insbesondere das Aufbringen von Klebeflächen und von Bauteilen sowie das (Laser)bohren zur Vorbereitung von Kontaktierungen an den Anschlüssen von Bauteilen in Hinblick auf die geringen Abmessungen der Anschlussflächen nur bei Ausrichten der verwendeten Werkzeuge auf Pass- oder Ausrichtmarken (nachfolgend auch allgemein als "Marken" bezeichnet), sogenannte "fiducials", durchgeführt werden kann, welche auf im Allgemeinen metallischen Leiterschichten, insbesondere in Form von Bohrungen angebracht werden.

Bei den oben genannten "face down" Einbettungsverfahren werden solche Ausrichtmarken zunächst für das Bestücken mit Bauteilen verwendet, d.h. die Bestückungsmaschine wird von oben auf die Marken ausgerichtet und die Bauteile werden von oben auf die metallische Leiterschicht aufgebracht. Bei dem später durchzuführenden Schritt des Laserbohrens für die Kontaktierungen des Bauteils werden die Ausrichtmarken nun von unten erfasst, um die Einrichtung zum Laserbohren entsprechend zu justieren, mit der von unten durch die metallische Leiterschicht gebohrt wird. Auf diese Weise können hinsichtlich der Positionierung der Bohrungen sehr hohe Genauigkeiten erzielt werden, die in Hinblick auf die äußerst geringen Abmessungen der Anschlussflächen (Kontaktierungen) der einzubettenden Bauteile erforderlich sind.

Im Gegensatz dazu ist bei den bekannten "face up" Einbettungsverfahren kein direkter Bezug zwischen der Bestückungslage der Leiterplatte und der Kontaktierungslage der Bauteile gegeben. Üblicherweise werden hier nämlich zunächst Ausrichtmarken zum Bestücken mit Bauteilen von unten erfasst und sodann werden Durchgangsbohrungen durch den gesamten Aufbau von unten nach oben hergestellt. Diese Durchgangsbohrungen dienen als weitere Ausrichtmarken und werden von oben erfasst, um die Kontaktbohrungen zu den Anschlussflächen der Bauteile an den richtigen Stellen herstellen zu können. Insbesondere beim Herstellen der Durchgangsbohrungen kommt es durch die dabei verwendeten Vorrichtungen zu Ungenauigkeiten, die sich in nachteiliger Weise auf die nachfolgend durchgeführten Kontaktierungen auswirken. Bei einem solchen Verfahren ist mit Ungenauigkeiten im Bereich von ± 60µm zu rechnen, was einer weiteren Miniaturisierung Grenzen setzt.

Beispielsweise ist aus dem Dokument WO 2005/104636 A1 bereits ein zweistufiges Ausrichteverfahren bekannt, bei dem ein einzubettender elektronischer Bauteil anhand eines ersten Satzes von Ausrichtbohrungen in seiner Lage innerhalb einer Leiterplatte ausgerichtet wird. Anschließend wird ein zweiter Satz von Ausrichtmarken in Form von Durchgangsbohrungen hergestellt, welche zum Ausrichten weiterer außenseitiger Strukturen der Leiterplatte dienen.

Es ist eine Aufgabe der Erfindung, die erzielbare Genauigkeit bei der Herstellung einer Leiterplatte mit eingebetteten Bauteilen zu erhöhen, ohne dass dies zu einem hohen Aufwand hinsichtlich Zeit und Kosten führt. Es ist weiters eine Aufgabe der Erfindung, die eingangs beschriebenen Problematiken bei der "face down"-Bestückung bzw. Einbettung zu umgehen.

Diese Aufgabe wird mit einem Verfahren der eingangs genannten Art gelöst, welches erfindungsgemäß durch die folgenden Schritte gekennzeichnet ist:
a) Bereitstellen einer unteren Leiterfolie, die auf einer ersten metallischen Stützschicht aufgebracht ist,
b) Ausbilden von Ausrichtmarken zumindest in der Leiterfolie,
c) an den Ausrichtmarken registriertes Aufbringen zumindest einer Klebeschicht zum Festlegen zumindest eines Bauteils,
d) an den Ausrichtmarken registriertes Aufsetzen eines Bauteiles mit seiner Rückseite auf der Klebeschicht, wobei die Anschlussflächen des Bauteiles nach oben zeigen, und Aushärten des Klebers der zumindest einen Klebeschicht,
e) Einbetten des Bauteils in eine Isolierschicht,
f) Aufbringen einer metallischen oberen Leiterfolie und einer oberen metallischen Stützschicht,
g) Verpressen und Verfestigen des gesamten Aufbaus,
h) Entfernen der Stützschichten,
i) Freilegen der Ausrichtmarken der unteren Leiterfolie durch Abtragen der Isolierschicht im Bereich der Ausrichtmarken und Erzeugen entsprechender Freistellungen,
j) an den Ausrichtmarken registriertes Herstellen von Bohrungen mittels Laser zu den Anschlussflächen des Bauteils und
k) Aufbringen einer Leiterschicht zumindest an der Oberseite des Aufbaus, Herstellen von Kontaktierungen in den Bohrungen zu den Anschlussflächen des Bauteiles sowie Strukturieren der Leiterschicht zur Herstellung von Leiterbahnen.

Dank der Erfindung ist bei einem face up Einbettungsverfahren nur noch ein einmaliges Ausrichten auf Ausrichtmarken erforderlich, wodurch sich im Gegensatz zu den nach dem Stand der Technik bekannten Verfahren erheblich höhere Genauigkeiten bei der Herstellung der Kontaktbohrungen erzielen lassen. Durch den direkten Bezug zwischen Bestückungs- und Kontaktierungslage lassen sich also wesentlich höhere Genauigkeiten erzielen als bei gängigen Registrierungsverfahren. Tatsächlich ergeben sich Genauigkeiten im Bereich von ± 20µm.

In Hinblick auf die Verwendung eines Klebstoffes zum Festlegen der Bauteile ist es zweckmäßig, wenn die untere und/oder obere Leiterfolie mit einer isolierenden Beschichtung versehen ist, da durch diese die verhältnismäßig raue Oberfläche der Leiterfolien, die meist aus Kupfer bestehen, abgedeckt ist. Dadurch wird z.B. der sog. "Bleeding"-Effekt vermieden, bei dem Lösungsmittel aus dem Klebstoff entweicht und es zu einem Austrocknen des Klebstoffes kommt.

In Hinblick auf eine kostengünstige und bewährte Herstellung ist es zweckmäßig, wenn die Leiterfolien und die Stützschichten aus Kupfer bestehen.

Da Laserbohreinrichtungen üblicherweise auch für andere Bohrvorgänge während des Herstellungsprozesses zur Verfügung stehen, ist es vorteilhaft, falls die Ausrichtmarken durch Laserbohren ausgebildet werden. Es hat sich besonders bewährt, wenn das Laserbohren mit Hilfe eines UV-Lasers erfolgt.

Es ist kostengünstig und praxisbewährt, dass die Klebeschicht durch Siebdruck aufgebracht wird.

Falls in Schritt d) ein Ausrichten auf Aussenkanten und/oder Anschlussflächen des Bauteils erfolgt, erreicht man eine besonders hohe Genauigkeit bei später folgenden Arbeitsschritten.

Zur Erzielung hoher Packungsdichten ist es zweckmäßig, wenn das Bauteil als gedünnter Chip ausgebildet ist.

In der Praxis hat es sich als besonders zweckmäßig und kostengünstig erwiesen, wenn die Isolierschicht aus einer dem zumindest einem Bauteil entsprechend ausgeschnittener Folie sowie aus einer darüber angeordneten, durchgehenden Deckfolie besteht.

Zur raschen und sicheren Herstellung und zum Vermeiden des Verbleibens von Feuchtigkeitsresten ist es sinnvoll, wenn in Schritt g) mechanischer Pressdruck, erhöhte Temperatur sowie Unterdruck (Vakuum) auf den Aufbau angewendet wird.

Die bei der Herstellung der Freistellungen geforderte Präzision bezüglich der Bohrungstiefe lässt sich besonders leicht erreichen, wenn im Schritt i) die Freistellungen mit Hilfe einer Pikosekunden-Laserbohrtechnik hergestellt werden.

Es hat sich als vorteilhaft erwiesen, wenn bei der Herstellung der Bohrungen in Schritt j) in einem ersten Teilschritt zunächst mit einem UV-Laser die obere Leiterfolie entfernt wird und sodann in einem zweiten Teilschritt mittels eines CO₂-Lasers die Schicht bis zu den Anschlussflächen der Bauteile entfernt wird.

Andererseits lässt sich der Geräteaufwand bei der Anwendung des Verfahrens verringern, wenn in Schritt j) die Bohrungen in einem einzigen Arbeitsschritt mit Hilfe einer Pikosekunden-Laserbohrtechnik hergestellt werden.

Eine Leiterplattenstruktur mit zumindest einem eingebetteten Bauteil, das auf einer unteren Leiterfolie durch Kleben befestigt ist und dessen Anschlussflächen nach oben zeigen, welche durch ein Verfahren nach der Erfindung hergestellt ist, zeichnet sich durch eine hohe Zuverlässigkeit bei sehr großer Packungsdichte aus. Erfindungsgemäß sind bei einer solchen Leiterplattenstruktur Ausrichtmarken zumindest in der Leiterfolie ausgebildet und jeweils an den Ausrichtmarken registriert ist zumindest eine Klebeschicht zum Festlegen des zumindest einen eingebetteten Bauteils aufgebracht, wobei das zumindest eine eingebettete Bauteil mit seiner Rückseite auf der Klebeschicht an den Ausrichtmarken registriert aufgesetzt ist, die Ausrichtmarken der unteren Leiterfolie freigelegt sind, wobei die Isolierschicht im Bereich der Ausrichtmarken unter Bildung entsprechender Freistellungen abgetragen ist, sowie Bohrungen mittels Laser zu den Anschlussflächen des Bauteils an den Ausrichtmarken registriert hergestellt sind.

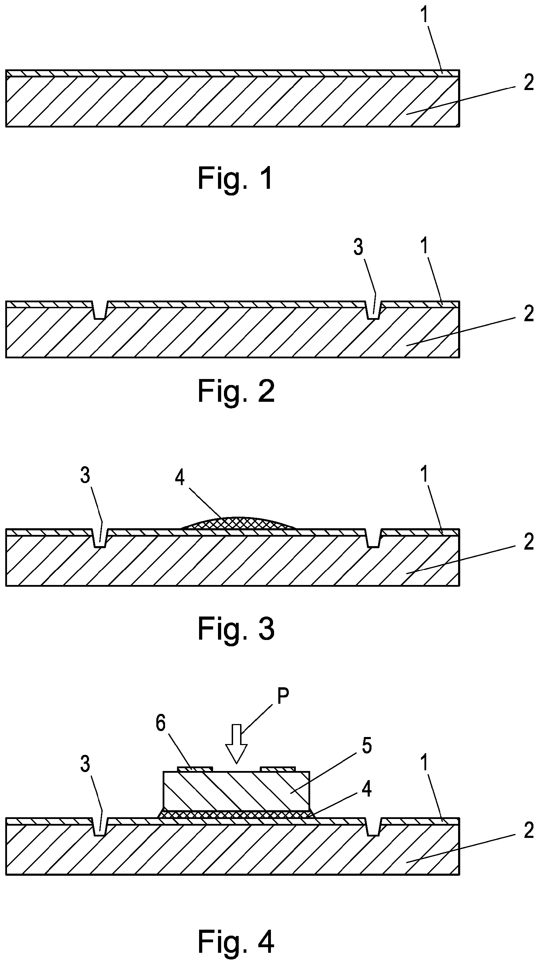

Die Erfindung samt weiteren Vorteilen ist im Folgenden an Hand beispielsweiser Ausführungsformen näher erläutert, die in der Zeichnung veranschaulicht sind. In dieser zeigen die Fig. 1 bis 10 die einzelnen Verfahrensschritte der Erfindung zum Aufbau einer Leiterplattenstruktur mit zumindest einem Bauteil je in schematischen Schnitten eines Teils einer Leiterplatte.

Unter Bezugnahme auf die Fig. 1 bis 10 wird nun das Verfahren nach der Erfindung zur Herstellung einer Leiterpatte mit zumindest einem integrierten Bauelement bzw. eine solche Leiterplatte nach der Erfindung beschrieben.

Fig. 1 zeigt den ersten Schritt des Verfahrens, nämlich die Bereitstellung einer dünnen unteren Leiterfolie 1, beispielsweise einer 2 µm Cu-Folie, die auf einer stärkeren unteren Stützschicht 2, beispielsweise einer 70 µm Cu-Folie abgestützt ist, wobei die Schichten 1 und 2 miteinander verbunden sind. Die Kombination untere Leiterfolie /Stützschicht kann auch eine isolierende, hier nicht gezeigte Beschichtung, beispielsweise eine Harzschicht, besitzen, die an der Oberseite, d.h. an der Leiterfolie 1 aufgebracht ist, und die beispielsweise eine Stärke von 5 bis 15 µm besitzt. Durch eine solche Beschichtung wird die verhältnismäßig raue Oberfläche der Leiterfolien, die meist aus Kupfer bestehen, abgedeckt, was sich beim Festlegen der Bauteile mittels eines Klebers als zweckmäßig erwiesen hat.

Insbesondere wird durch eine derartige, im Vergleich zum Kupfer glatte Schicht der sog. "Bleeding"-Effekt, also das Entweichen des Lösungsmittels aus dem Klebstoff und das dadurch bedingte Austrocknen des Klebstoffs, reduziert.

Im nächsten Schritt gemäß Fig. 2 werden mittels eines Lasers, vorzugsweise eines UV-Lasers, Ausrichtmarken 3, sogenannte Fiducials, in die untere Leiterfolie 1 und durch diese hindurch auch in die Stützschicht 2 gebohrt. Solche Ausrichtmarken ermöglichen das Ausrichten (Registration) der Leiterplatte bezüglich jener Werkzeuge, welche später zur weiteren Herstellung bzw. Verarbeitung der Leiterplatte benötigt werden, und beispielsweise Klebstoff mittels Siebdruck aufbringen, die Bestückung mit Bauteilen vornehmen bzw. zum Herstellen von Bohrungen durch Laser dienen. Im Allgemeinen werden zumindest vier solcher Ausrichtmarken benötigt, ihre genaue Anzahl und Konfigurierung kann bzw. muss jedoch individuell gewählt werden.

Nun werden, wie in Fig. 3 illustriert, beispielsweise durch Walzbeschichten oder ein Druckverfahren, insbesondere ein Siebdruckverfahren, Klebeschichten 4 zum Festlegen von Bauteilen auf die untere Leiterfolie 1 aufgebracht, wie beispielsweise in den WO 2007/087660 A1 und WO 2009/143550 A1 der Anmelderin beschrieben. Nach dem Aufbringen der Klebeschichten 4 kann noch eine Vakuumbehandlung zum Entlüften des verwendeten Klebstoffs vorgenommen werden.

Danach, siehe Fig. 4, wird ein Bauteil 5, beispielsweise ein sogenannter "gedünnter", d.h. auf beispielsweise eine Dicke von 50 bis 200 µm abgeschliffener Chip, im Bereich der Klebeschicht 4 durch eine mit den Ausrichtmarken 3 ausgerichtete Bestückungsmaschine mit seiner Rückseite auf der unteren Leiterfolie 1 angeordnet. Hierbei erfolgt ein Ausrichten auf die Außenkanten und leitende Anschlussflächen 6 des Bauteils 5. Im Allgemeinen werden natürlich mehrere Bauteile 5 gleichzeitig auf die metallische Leiterschicht 1 aufgebracht. Der Kleber der Klebeschicht bzw. Klebeschichten 4 kann nun in bekannter Weise, insbesondere thermisch, ausgehärtet werden. Ein Pfeil P in Fig. 4 soll die Anwendung eines gewissen Anpressdrucks andeuten.

Durch das thermische Aushärten bzw. das Entlüften des Klebstoffs wird auch das oben geschilderte Problem von Luft- bzw. Feuchtigkeitseinschlüssen im Klebstoff behoben.

Als Bauteile kommen außer Chips, welche hochintegrierte Schaltungen enthalten, auch andere in der Elektronik verwendete Bauteile in Frage, beispielsweise Widerstände, Kondensatoren etc.

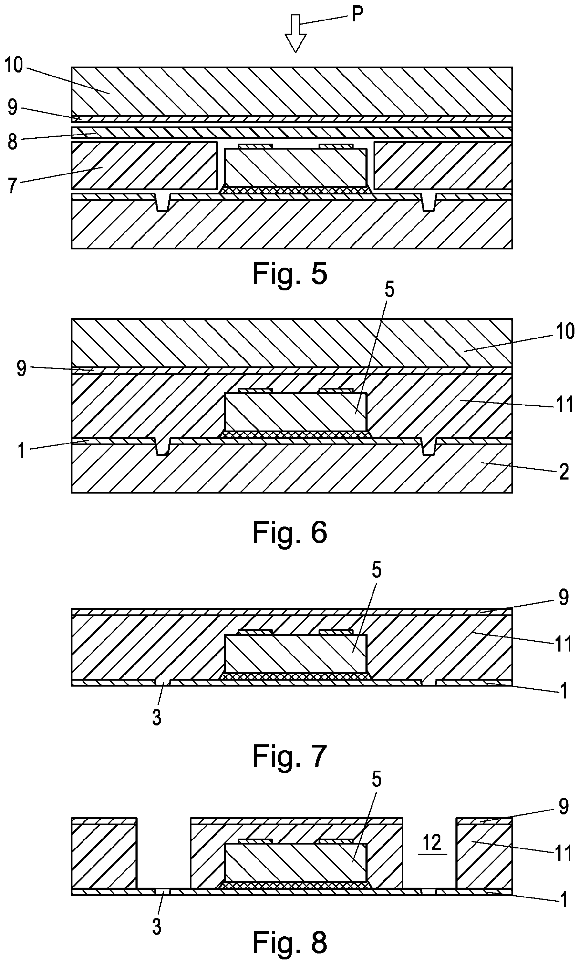

Nach dem Aufbringen des Bauteils 5 erfolgt dessen eigentliches Einbetten durch Aufbringen einer ausgeschnittenen Folie 7 sowie einer Deckfolie 8, wobei nun auf Fig. 5 Bezug genommen wird. Als ausgeschnittene Folie 7 wird in diesem Beispiel eine FR4-Folie (eine mit Epoxidharz getränkte Glasfasermatte) in einer Stärke aufgebracht, welche die Höhe des Bauteils einschließlich der Dicke der Klebeschicht 4 übersteigt, sodass eine Druckentlastung des Bauteils 5 während nachfolgender Verpressvorgänge sichergestellt ist. Zum homogenen Ausfüllen der Hohlräume zwischen dem bestückten Bauteil 5 und der ausgeschnittenen Folie 7 wird nun die nicht ausgeschnittene Deckfolie 8 über den bereits vorhandenen Aufbau gelegt. Auf die Deckfolie 8 folgt eine obere Leiterfolie 9, insbesondere eine Cu-Folie, samt einer darauf angeordneten oberen Stützschicht 10, die gleichfalls als Cu-Folie ausgebildet sein kann. Die obere Leiterfolie 9 kann, ebenso wie die untere Leiterfolie 1 eine isolierende Beschichtung an ihrer dem Bauteil 5 zugewandten Seite besitzen. Die Schichten bzw. Folien 1,2 und 9, 10 liegen spiegelbildlich zueinander. Der Aufbau wird nun unter Anwendung von mechanischem Pressdruck, Temperatur und Unterdruck (Vakuum) verpresst, was wieder durch einen Pfeil P angedeutet ist.

Fig. 6 zeigt das Ergebnis des genannten Verpressens, wobei zu beachten ist, dass nunmehr auch die Ausrichtmarken 3 nicht mehr "sichtbar" sind. Die Folien 7 und 8 bilden nun eine praktisch einstückige Isolierschicht 11, die auch die Ausrichtmarken 3 ausfüllt.

In einem nächsten Schritt werden die untere und die obere Stützschicht 2 und 10 entfernt, vorzugsweise durch einfaches Abziehen, wodurch man zu dem in Fig. 7 gezeigten Aufbau gelangt.

In einem weiteren Schritt, siehe Fig. 8, können nun die in der unteren Leiterfolie 1 vorhandenen Ausrichtmarken 3 so freigelegt werden, dass sie von oben "sichtbar" werden. Zu diesem Zweck erfolgt ein Abtragen der oberen Leiterfolie 9 und der darunterliegenden Isolierschicht 11 (FR4-Folien) im Bereich der Ausrichtmarken 3 bis zu der unteren Leiterfolie 1, die jedoch erhalten bleiben muss, sodass Freistellungen 12 entstehen. Problematisch ist hier die geringe Dicke dieser Leiterfolie 1, im Beispiel eine 2 µm Cu-Folie, und es hat sich in Versuchen gezeigt, dass zur Durchführung dieses Vorgangs ein Ultrakurzpuls-Laser, insbesondere ein Pikosekunden-Laser, das Mittel der Wahl ist. Tatsächlich wird bei kürzerer Pulslänge mit einem Puls weniger Material abgetragen, wodurch sich eine sehr gute Tiefenkontrolle erreichen lässt.

Bei Verwendung eines Pikosekunden-Lasers lassen sich auch thermische Effekte soweit verringern, dass keine Karbonisierung des FR4-Materials erfolgt.

Mit einem solchen, im Handel erhältlichen Laser kann man dank der kurzen Pulslänge das Abtragen des Materials tatsächlich oder unmittelbar oberhalb der dünnen Leiterfolie 1 abstoppen, sodass die Ausrichtmarken 3 erhalten bleiben. Diese Tiefenkontrolle lässt sich weiter begünstigen durch das oben erwähnte Aufbringen von isolierenden Beschichtungen mit im Vergleich zum darüberliegenden Material unterschiedlichen Abtragungseigenschaften. Wie in Fig. 8 ersichtlich, sind die erzeugten Freistellungen 12 erheblich ausgedehnter, d.h. im Allgemeinen von größerem Durchmesser als die Ausrichtmarken 3, sodass keine allzu hohen Anforderungen an die Ausrichtung des verwendeten Pikosekunden-Lasers gestellt werden.

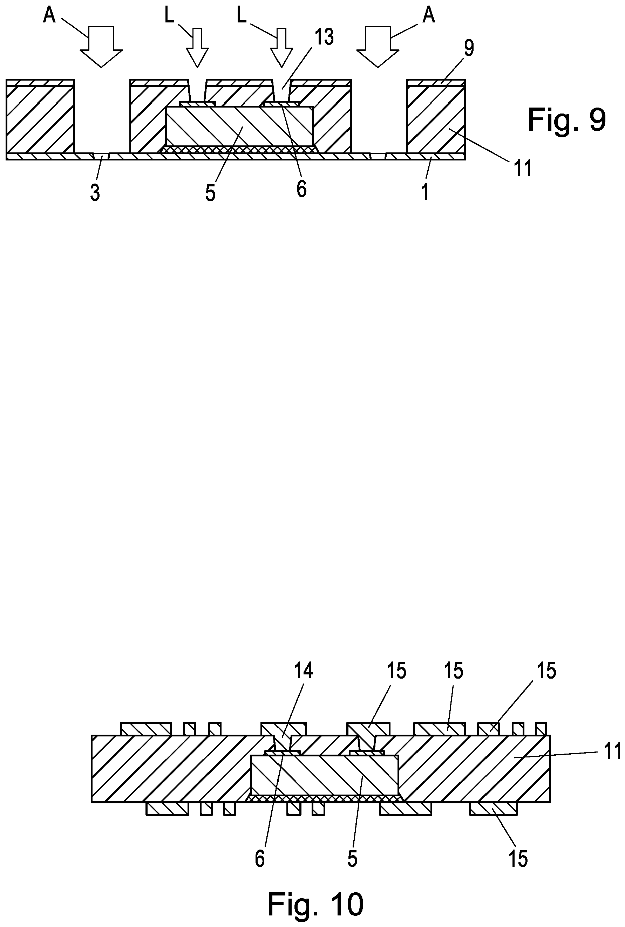

Sobald die Ausrichtmarken 3 freigelegt sind, können sie zum genauen optischen Ausrichten der Geräte für die folgenden Arbeitsschritte verwendet werden, was in Fig. 9 durch Pfeile A symbolisiert ist, welche die "Blickrichtung" der Ausrichtoptik darstellen. An dieser Stelle sei angemerkt, dass es auch ausreichend sein kann, die Ausrichtmarken "optisch" freizustellen, d.h. mit dem Pikosekunden-Laser nur soweit Material abzutragen, dass noch eine dünne, einige Mikrometer starke Schicht des FR4-Materials über den Ausrichtmarken 3 verbleibt, die optisch durchlässig ist, sodass die Marken durch diese Schicht hindurch von den verwendeten Kameras erfasst werden können. Der Begriff "Freilegen der Ausrichtmarken" ist somit in dem Sinn zu verstehen, dass dieses Freilegen zumindest soweit erfolgt, dass es ein optisches Erfassen dieser Marken ermöglicht.

Nach dem genauen Ausrichten können zur Vorbereitung der Kontaktierung Bohrungen 13 mit Hilfe z.B. eines CO₂-Lasers (Pfeile L) hergestellt werden. Da diese Bohrungen 13 bei sehr genauer Ausrichtung erzeugt werden, können auch kleine Anschlussflächen 6 mit Sicherheit kontaktiert werden, sodass auch viele Anschlüsse 6 auf sehr kleinen Bauteilen 5 möglich sind.

In der Praxis hat es sich als günstig erwiesen, ein kombiniertes Verfahren bei der Herstellung der Bohrungen 13 anzuwenden, bei welchem zunächst mit einem UV-Laser die Schicht 9, die meist aus Kupfer besteht, mit einem definierten Durchmesser abgetragen, d.h. die Bohrung "geöffnet" wird, und sodann mittels eines CO₂-Lasers das FR4-Material der Schicht 11 bis zu den Anschlussflächen 6 der Bauteile 5 entfernt werden.

Eine alternative Möglichkeit zur Herstellung der Bohrungen 13 besteht darin, diese Bohrungen in einem einzigen Arbeitsschritt mit Hilfe jenes Pikosekunden-Lasers herzustellen, der zuvor auch für das Freilegen der Ausrichtmarken 3 verwendet wurde. Auf diese Weise erübrigt sich die Verwendung unterschiedlicher Lasersysteme bei der Durchführung des erfindungsgemäßen Verfahrens.

Gemäß Fig. 10 erfolgt die Herstellung von Kontaktierungen 14 in den Bohrungen 13 durch beidseitiges galvanisches Aufbringen von Kupfer und die Strukturierung der oberen und unteren Kupferschichten, z.B. durch ein photolitographisches Verfahren zur Herstellung von Leiterbahnen 15. Natürlich könnten auch Durchkontaktierungen zwischen oberen und unteren Leiterbahnen hergestellt werden.

## Patentansprüche

1. Verfahren zum Einbetten zumindest eines Bauteiles, das auf einer unteren Leiterfolie durch Kleben befestigt ist und dessen Anschlussflächen nach oben zeigen, in eine Leiterplatte, **gekennzeichnet durch** die folgenden Schritte:
a) Bereitstellen einer unteren Leiterfolie (1), die auf einer ersten metallischen Stützschicht (2) aufgebracht ist,
b) Ausbilden von Ausrichtmarken (3) zumindest in der Leiterfolie (1),
c) an den Ausrichtmarken (3) registriertes Aufbringen zumindest einer Klebeschicht (4) zum Festlegen zumindest eines Bauteils,
d) an den Ausrichtmarken (3) registriertes Aufsetzen eines Bauteiles (5) mit seiner Rückseite auf der Klebeschicht (4), wobei die Anschlussflächen (6) des Bauteiles nach oben zeigen, und Aushärten des Klebers der zumindest einen Klebeschicht,
e) Einbetten des Bauteils (5) in eine Isolierschicht (11),
f) Aufbringen einer metallischen oberen Leiterfolie (9) und einer oberen metallischen Stützschicht (10),
g) Verpressen und Verfestigen des gesamten Aufbaus,
h) Entfernen der Stützschichten (2,10),
i) Freilegen der Ausrichtmarken (3) der unteren Leiterfolie (1) durch Abtragen der Isolierschicht (11) im Bereich der Ausrichtmarken und Erzeugen entsprechender Freistellungen (12),
j) an den Ausrichtmarken (3) registriertes Herstellen von Bohrungen (13) mittels Laser zu den Anschlussflächen (6) des Bauteils (5) und
k) Aufbringen einer Leiterschicht zumindest an der Oberseite des Aufbaus, Herstellen von Kontaktierungen (14) in den Bohrungen (13) zu den Anschlussflächen (6) des Bauteiles (5) sowie Strukturieren der Leiterschicht zur Herstellung von Leiterbahnen (15).

2. Verfahren nach Anspruch 1, **dadurch gekennzeichnet, dass** die untere und/oder obere Leiterfolie (1, 9) mit einer isolierenden Beschichtung versehen ist.

3. Verfahren nach Anspruch 1 oder 2, **dadurch gekennzeichnet, dass** die Leiterfolien (1, 9) und die Stützschichten (2, 10) aus Kupfer bestehen.

4. Verfahren nach Anspruch 1, **dadurch gekennzeichnet, dass** in Schritt b) die Ausrichtmarken (3) durch Laserbohren ausgebildet werden.

5. Verfahren nach Anspruch 4, **dadurch gekennzeichnet, dass** in Schritt b) das Laserbohren mit Hilfe eines UV-Lasers erfolgt.

6. Verfahren nach Anspruch 1, **dadurch gekennzeichnet, dass** in Schritt c) die Klebeschicht (4) durch Siebdruck aufgebracht wird.

7. Verfahren nach Anspruch 1, **dadurch gekennzeichnet, dass** in Schritt d) ein Ausrichten auf Aussenkanten und/ oder Anschlussflächen (6) des Bauteils (5) erfolgt.

8. Verfahren nach Anspruch 1, **dadurch gekennzeichnet, dass** das Bauteil (5) als gedünnter Chip ausgebildet ist.

9. Verfahren nach Anspruch 1, **dadurch gekennzeichnet, dass** die Isolierschicht (11) aus einer dem zumindest einem Bauteil (5) entsprechend ausgeschnittener Folie (7) sowie aus einer darüber angeordneten, durchgehenden Deckfolie (8) besteht.

10. Verfahren nach Anspruch 1, **dadurch gekennzeichnet, dass** in Schritt g) mechanischer Pressdruck, erhöhte Temperatur sowie Unterdruck (Vakuum) auf den Aufbau angewendet werden.

11. Verfahren nach Anspruch 1, **dadurch gekennzeichnet, dass** in Schritt i) die Freistellungen (12) mit Hilfe einer Pikosekunden-Laserbohrtechnik hergestellt werden.

12. Verfahren nach Anspruch 1, **dadurch gekennzeichnet, dass** bei der Herstellung der Bohrungen (13) in Schritt j) in einem ersten Teilschritt zunächst mit einem UV-Laser die obere Leiterfolie (9) entfernt wird und sodann in einem zweiten Teilschritt mittels eines CO₂-Lasers die Schicht (11) bis zu den Anschlussflächen (6) der Bauteile (5) entfernt wird.

13. Verfahren nach Anspruch 1, **dadurch gekennzeichnet, dass** in Schritt j) die Bohrungen (13) in einem einzigen Arbeitsschritt mit Hilfe einer Pikosekunden-Laserbohrtechnik hergestellt werden.

14. Leiterplattenstruktur mit zumindest einem eingebetteten Bauteil (5), das auf einer unteren Leiterfolie (1) durch Kleben befestigt ist und dessen Anschlussflächen (6) nach oben zeigen, **dadurch gekennzeichnet, dass** die Leiterplattenstruktur durch ein Verfahren nach einem der vorgehenden Ansprüche 1 bis 13 hergestellt ist, wobei Ausrichtmarken (3) zumindest in der Leiterfolie (1) ausgebildet sind und jeweils an den Ausrichtmarken (3) registriert zumindest eine Klebeschicht (4) zum Festlegen des zumindest einen eingebetteten Bauteils (5) aufgebracht ist, das zumindest eine eingebettete Bauteil (5) mit seiner Rückseite auf der Klebeschicht (4) an den Ausrichtmarken (3) registriert aufgesetzt ist, die Ausrichtmarken (3) der unteren Leiterfolie (1) freigelegt sind, wobei die Isolierschicht (11) im Bereich der Ausrichtmarken (3) unter Bildung entsprechender Freistellungen (12) abgetragen ist, sowie Bohrungen (13) mittels Laser zu den Anschlussflächen (6) des Bauteils (5) an den Ausrichtmarken (3) registriert hergestellt sind.

15. Leiterplattenstruktur nach Anspruch 14, **dadurch gekennzeichnet, dass** die Ausrichtmarken (3) zumindest in der Leiterfolie (1) durch Laserbohren hergestellt sind.

## Claims

1. A method for embedding at least one component, which is attached to a lower conductor foil through adhesion and the connection surfaces of which face upwards, in a printed circuit board, **characterised by** the following steps:
a) providing a lower conductor foil (1) which is applied on a first metallic support layer (2),
b) creating alignment marks (3) at least in the conductor foil (1),
c) registered application of at least one adhesive layer (4) on the alignment marks (3) for fastening at least one component,
d) registered placing of a component (5) on the alignment marks (3) with a rear side on the adhesive layer (4), wherein the connection surfaces (6) of the component face upwards, and hardening of the adhesive of the least one adhesive layer,
e) embedding of the component (5) into at least one insulating layer (11),
f) applying a metallic upper conductor foil (9) and an upper metallic support layer (10),
g) pressing and strengthening the entire assembly,
h) removing the supporting layers (2, 10),
i) exposing the alignment marks (3) of the lower conductor foil (1) by removing the insulating layer (11) in the area of the alignment marks and producing corresponding exposed areas (12),
j) at the alignment marks (3) registered creation of borings (13) by means of laser to the connection surfaces (6) of the component (5) and
k) applying a conductor layer at least on the upper side of the assembly, creating contact (14) in the borings (13) to the connection surfaces (6) of the component (5) as well as structuring of the conductor layer to produce conductor paths (15).

2. The method according to claim 1, **characterised in that** the lower and/or upper conductor foil (1, 9) is provided with an insulating coating.

3. The method according to claim 1 or 2, **characterised in that** the conductor foils (1, 9) and the support layers (2, 10) are made of copper.

4. The method according to claim 1, **characterised in that** in step b) the alignment marks (3) are created by laser boring.

5. The method according to claim 4, characterised that in step b) the laser boring takes place with the aid of an UV laser.

6. The method according to claim 1, **characterised in that** in step c) the adhesive layer (4) is applied by screen printing.

7. The method according to claim 1, **characterised in that** in step d) alignment to outer edges and/or connection surfaces (6) of the component (5) takes place.

8. The method according to claim 1, **characterised in that** the component (5) is embodied as a thinned chip.

9. The method according to claim 1, **characterised in that** the insulating layer (11) comprises a cut out foil (7) corresponding to the at least one component (5) as well as a continuous cover foil (8) arranged above it.

10. The method according to claim 1, **characterised in that** in step g) mechanical pressure, increased temperature and negative pressure (vacuum) are used on the assembly.

11. The method according to claim 1, **characterised in that** in step i) the exposed areas (12) are produced using a picosecond laser boring technique.

12. The method according to claim 1, **characterised in that** in the production of the borings (13) in step j) in a first partial step the upper conductor foil (9) is first removed with a UV laser and then in a second partial step the layer (11) is removed up to the connection surfaces (6) of the components (5) by means of a CO₂ laser.

13. The method according to claim 1, **characterised in that** in step j) the borings (13) are produced in a single working step using a picosecond laser boring technique.

14. A printed circuit board structure with at least one embedded component (5) which is attached to a lower conductor foil (1) though adhesion and the connection surfaces (6) of which face upwards, **characterised in that** the printed circuit board structure is produced by a method according to any one of preceding claims 1 to 13, wherein alignment marks (3) are created at least in the conductor foil (1) and registered on each of the alignment marks (3) an adhesive layer (4) is applied for fastening the at least one embedded component (5), the at least one embedded component (5) is applied with its rear side on the adhesive layer (4) registered on the alignment marks (3), the alignment marks (3) of the lower conductor foil (1) are exposed, wherein the insulating layer (11) is removed in the area of the alignment marks (3) forming corresponding exposed areas (12), and borings (13) to the connection surface (6) of the component (5) are created registered on the alignment marks (3).

15. The printed circuit board structure according to claim 14, **characterised in that** the alignment marks (3) at least in the conductor foil (1) are produced by laser boring.

## Revendications

1. Procédé permettant d'intégrer au moins un composant, qui est fixé par collage sur une feuille de circuit imprimé inférieure et dont les surfaces de connexion sont dirigées vers le haut, dans une carte de circuit imprimé, **caractérisé par** les étapes suivantes :
a) préparation d'une feuille de circuit imprimé inférieure (1), qui est appliquée sur une première couche de support métallique (2),
b) formation de repères d'orientation (3) au moins dans la feuille de circuit imprimé (1),
c) mise en place enregistrée sur les repères d'orientation (3) d'au moins une couche de colle (4) pour fixer au moins un composant,
d) dépose enregistrée sur les repères d'orientation (3) d'un composant (5) avec sa face arrière sur la couche de colle (4), sachant que les surfaces de connexion (6) du composant sont dirigées vers le haut et durcissement de l'adhésif d'au moins une couche de colle,
e) intégration du composant (5) dans une couche isolante (11),
f) mise en place d'une feuille de circuit imprimé (9) supérieure métallique et d'une couche de (10) métallique supérieure,
g) compression et consolidation de l'ensemble de la structure,
h) enlèvement des couches de support (2, 10),
i) dégagement des repères d'orientation (3) de la feuille de circuit imprimé inférieure (1) par abstraction de la couche isolante (11) dans la zone des repères d'orientation et production de points libres correspondants (12),
j) réalisation enregistrée sur les repères d'orientation (3) de perçages (13) au moyen du laser pour les surfaces de connexion (6) du composant (5), et
k) mise en place d'une couche de circuit imprimé au moins sur la face supérieure de la structure, réalisation de contacts (14) dans les perçages (13) pour les surfaces de connexion (6) du composant (5) ainsi que structuration de la couche de circuit imprimé pour la réalisation des pistes conductrices (15).

2. Procédé selon la revendication 1, **caractérisé en ce que** la feuille de circuit imprimé inférieure et/ou supérieure (1, 9) est dotée d'un revêtement isolant.

3. Procédé selon la revendication 1 ou 2, **caractérisé en ce que** les feuilles de circuit imprimé (1, 9) et les couches de support (2, 10) sont en cuivre.

4. Procédé selon la revendication 1, **caractérisé en ce que** dans l'étape b) les repères d'orientation (3) sont constitués par perçage au laser.

5. Procédé selon la revendication 4, **caractérisé en ce que** dans l'étape b), le perçage au laser a lieu à l'aide d'un laser UV.

6. Procédé selon la revendication 1, **caractérisé en ce que** dans l'étape c), la couche de colle (4) est appliquée par sérigraphie.

7. Procédé selon la revendication 1, **caractérisé en ce que** dans l'étape d), une orientation a lieu sur les bords extérieurs et/ou surfaces de connexion (6) du composant (5).

8. Procédé selon la revendication 1, **caractérisé en ce que** le composant (5) est constitué sous la forme d'une puce amincie.

9. Procédé selon la revendication 1, **caractérisé en ce que** la couche isolante (11) est composée d'une feuille (7) découpée de façon correspondante au moins à un composant (5) ainsi que d'une feuille de couverture (8) continue disposée dessus.

10. Procédé selon la revendication 1, **caractérisé en ce que** dans l'étape g), on utilise de la pression de compression mécanique, une température élevée ainsi que de la dépression (vide) sur la structure.

11. Procédé selon la revendication 1, **caractérisé en ce que** dans l'étape i), les points libres (12) sont réalisés à l'aide d'une technique de perçage au laser en picosecondes.

12. Procédé selon la revendication 1, **caractérisé en ce que** lors de la réalisation des perçages (13) dans l'étape j), la feuille de circuit imprimé supérieure (9) est enlevée dans une première partie d'étape d'abord avec un laser UV et la couche (11) est ensuite enlevée dans une deuxième partie d'étape au moyen d'un laser au CO₂ jusqu'aux surfaces de connexion (6) des composants (5).

13. Procédé selon la revendication 1, **caractérisé en ce que** dans l'étape j), les perçages (13) sont réalisés dans une étape de travail unique à l'aide d'une technique de perçage au laser en picosecondes.

14. Structure de carte de circuit imprimé avec au moins un composant (5) intégré, qui est fixé par collage sur une feuille de circuit imprimé (1) inférieure et dont les surfaces de connexion (6) sont dirigées vers le haut, **caractérisée en ce que** la structure de carte de circuit imprimé est réalisée par un procédé selon l'une quelconque des revendications 1 à 13, sachant que les repères d'orientation (3) sont constitués au moins dans la feuille de circuit imprimé (1) et qu'au moins une couche de colle (4) est respectivement appliquée de façon enregistrée sur les repères d'orientation (3) pour fixation d'au moins un composant (5) intégré, au moins un composant (5) intégré est déposé avec sa face arrière sur la couche de colle (4) de façon enregistrée sur les repères d'orientation (3), les repères d'orientation (3) de la feuille de circuit imprimé (1) inférieure sont libérés, sachant que la couche isolante (11) est éliminée dans la zone des repères d'orientation (3) en formant des points libres correspondants (12), et les perçages (13) sont réalisés de façon enregistrée sur les repères d'orientation (3) au moyen du laser sur les surfaces de connexion (6) du composant (5).

15. Structure de carte de circuit imprimé selon la revendication 14, **caractérisée en ce que** les repères d'orientation (3) sont réalisés au moins dans la feuille de circuit imprimé (1) par perçage au laser.
